(19) **Europäisches Patentamt / European Patent Office / Office européen des brevets**

(11) **EP 2 706 370 A1**

(12) **EUROPEAN PATENT APPLICATION**

(43) Date of publication:
**12.03.2014 Bulletin 2014/11**

(51) Int Cl.:
***G01R 33/46*** (2006.01)

(21) Application number: **13183023.4**

(22) Date of filing: **04.09.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **05.09.2012 JP 2012194864**

(71) Applicant: **Jeol Resonance Inc.**
**Akishima**
**Tokyo 196-8558 (JP)**

(72) Inventors:
• **Nishiyama, Yusuke**
  **Akishima Tokyo 196-8558 (JP)**
• **Frey, Michael H.**
  **Peabody, MA 01960 (US)**

(74) Representative: **Boult Wade Tennant**
**Verulam Gardens**
**70 Gray's Inn Road**
**London WC1X 8BT (GB)**

(54) **NMR measurement method**

(57) A method of NMR measurement is offered which achieves background suppression based on a technique employing differences in RF magnetic field strength while alleviating the problem that less latitude is allowed in setting the number of signal accumulations. This method suppresses a background-derived signal emanating from the material of an NMR probe. The method starts with applying an RF pulse sequence consisting of a 90° pulse and subsequent one or more 180° pulses to a sample to induce an NMR signal and detecting the signal. This application is repeated while varying the RF phases of the pulses to induce NMR signals in accordance with a cogwheel phase-cycling scheme to induce NMR signals. The NMR signals are detected. The detected NMR signals are accumulated.

Fig.2

EP 2 706 370 A1

**Description**

**BACKGROUND OF THE INVENTION**

1. Field of the Invention

The present invention relates to a method of nuclear magnetic resonance (NMR) measurement and, more particularly, to a method used to suppress unwanted signals, known as a background signal. Often, an NMR spectrum is observed in which signals arising from substances (principally the material of the NMR probe) other than the sample under investigation are superimposed on the signal arising from the sample. Usually, the superimposed signals are called the background signal. Where the signal arising from the sample is sufficiently strong, a week background signal presents no serious problems. However, where a weak signal is observed as encountered when a trace amount of sample is measured, great problems take place.

Furthermore, even when a sufficient amount of sample under investigation exists, if a nuclide (such as $^{19}$F) that is also contained in large amounts in the material of the probe is measured, the background signal poses serious problems. In addition, a background signal is generally observed as a broad lineshape. Therefore, when the signal from the sample under investigation shows a broad lineshape, it is difficult to discriminate the sample-derived signal from the background signal. The present invention is employed to efficiently suppress the background signal that causes such problems.

Where $^{1}$H NMR measurements are performed, as is often the case, NMR probes made from fluorocarbon resins (such as Teflon (TM) by DuPont Co.) not containing $^{1}$H nuclei are often used to suppress the background signal. On the other hand, such probes hinder $^{19}$F NMR measurements. Furthermore, those materials which do not contain $^{13}$C nuclei are few in number. It is difficult to replace the material of the NMR probe by a material not giving a background signal in $^{13}$C NMR measurements that are often done.

Another technical approach to suppress the background signal is to use an ingeniously devised measuring method. Methods for extracting only sample-derived signals while suppressing the background signal have been proposed. However, these methods need a large number of signal accumulations to suppress the background signal and so the measurement time is long and the efficiency is low. The present invention belongs to a technical field of NMR measurement method for efficiently suppressing background signals in a short time.

2. Description of the Related Art

[Probe Material Of Interest]

As described previously, if the probe material does not contain the nuclide observed actually, the background problem will be solved. Since $^{1}$H nuclei are often measured, polymers containing $^{19}$F (hereinafter referred to as $^{19}$F polymers) such as Teflon that does not contain $^{1}$H nuclei are often used as probe materials. This suppresses not only the background signal from $^{1}$H nuclei but also the background signal even in multiple-nuclide NMR measurements involving $^{1}$H nuclei.

For example, in $^{13}$C-CPMAS (cross correlation magic-angle spinning) measurements which are widely used in solid-state NMR measurements, signals originating from $^{13}$C nuclei can be measured efficiently by transferring the magnetization of $^{1}$H nuclei to $^{13}$C nuclei. Therefore, if the probe material contains $^{13}$C nuclei, no background signal appears in the $^{13}$C-CPMAS spectrum as long as $^{1}$H nuclei do not exist in the material.

The same phenomenon is observed in solution NMR measurements. When $^{13}$C nuclei are directly observed, even if a background signal appears, the background signal of $^{13}$C nuclei can be removed by performing a measurement involved with $^{1}$H nuclei (such as HMQC or HSQC).

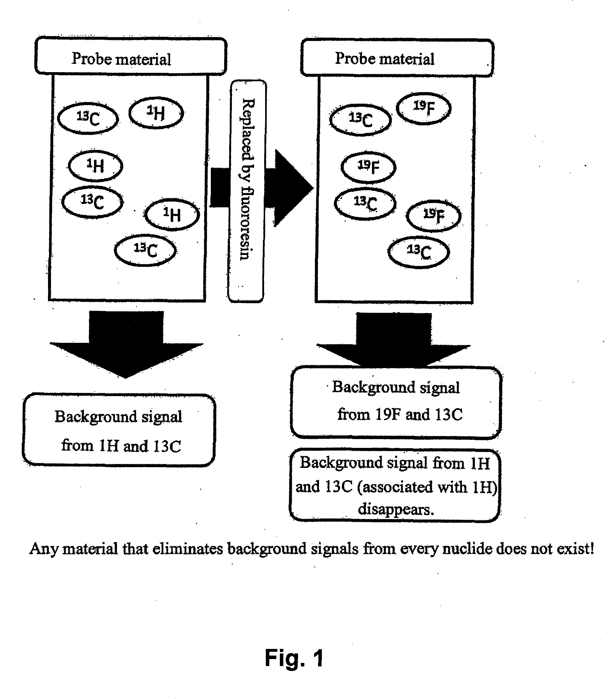

By using a polymer containing $^{19}$F as a probe material in this way, the background signal associated with $^{1}$H nuclei can be reduced greatly (FIG. 1), but, on the other hand, during measurement of $^{19}$F nuclei, a quite strong background signal arising from the $^{19}$F polymer is observed. With respect to $^{13}$C nuclei, background signals are not problematic in many $^{13}$C-CPMAS measurements. In the case of direct measurement of $^{13}$C nuclei not employing CP measurements, the background signal of $^{13}$C nuclei appears, for the following reason. If hydrogen nuclei are replaced by fluorine nuclei using a $^{19}$F polymer, the number of $^{13}$C nuclei itself is not reduced. Many materials not containing $^{13}$C nuclei, such as inorganic ceramic materials, contain $^{27}$Al nuclei or $^{29}$Si nuclei. These create a new background problem when $^{27}$Al NMR measurements or $^{29}$Si NMR measurements are performed.

As described so far, meticulous care is exercised in selecting an NMR probe material. In many cases, however, the background signal is suppressed at the expense of detection of any other nuclide. Consequently, any effective method that can be applied to every nuclide is unavailable.

[Approach using Differences in RF Magnetic Field Strength]

An NMR probe is designed to efficiently receive the signal intensity from a sample. Therefore, the RF magnetic field strength felt at the sample position is different from the RF magnetic field strength felt at other positions. An approach, known as DEPTHn, has been proposed to suppress the background signal while taking notice of this difference (non-patent documents 1 and 2).

In this approach, magnetization is first excited with a 90° pulse and then only a signal from magnetization subjected to an appropriate RF strength is extracted by applying one or more 180° pulses (whose number is n) in succession.

In particular, a DEPTH1 (or, simply, DEPTH) pulse sequence consisting of one 90° pulse and one 180° pulse is discussed. The pulse widths of the 90° pulse and 180° pulse are set precisely equal to a 90° pulse and a 180° pulse, respectively, at the sample position. In consequence, at the sample position, the 180° pulse does not function at all or acts as a simple inverted pulse.

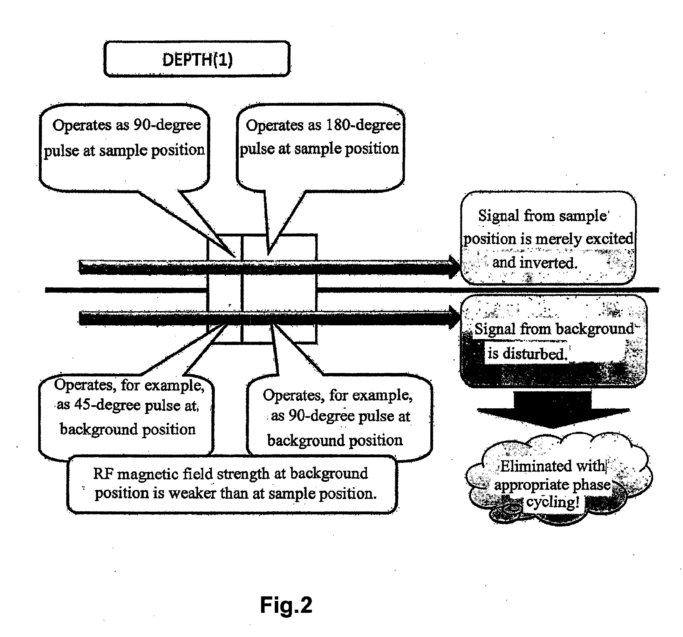

On the other hand, at positions different from the sample position, for example at a position where an RF magnetic field strength about half the RF magnetic field strength at the sample position is felt, a 90° pulse applied acts as a 45° pulse. A 180° pulse applied acts as a 90° pulse. Therefore, at positions different from the sample position, signals arising from nuclei present at positions other than the sample position are disturbed and thus behavior different from the signal arising from nuclei within the sample is exhibited (FIG. 2).

An experiment is repeatedly performed while varying the phases of the 90° pulse and 180° pulse individually, for example, in increments of 90°. The disturbed signal except the nuclei-derived signal can be removed by adding and removing the resulting signals while taking account of the pulse phases. This sequence is known as phase cycling. A pulse sequence consisting of one 90° pulse and two 180° pulses is known as DEPTH2. It is reported that the number of required phase cycles is 4 for each of these three pulses and thus the total number of phase cycles is 64.

In particular, the background signal cannot be removed until 64 experimental steps are performed. It is also reported that some performance is obtained by performing 16 phase cycling steps. Still, as many as 16 phase cycles are needed.

In this way, in the DEPTH approach using differences of RF magnetic field strength, phase cycling is necessary but the background signal can be removed neatly and only the signal from the sample can be extracted in principle. The present invention pertains to improvements of this technique.

Citation List

Non-patent Documents

Non-patent document 1: D.G. Cory, W.M. Ritchey, Journal of Magnetic Resonance, vol. 80, pp. 128-132 (1988).
Non-patent document 2: M.R. Bendall, R.E. Gordon, Journal of Magnetic Resonance, vol. 53, pp. 365-385 (1983).
Non-patent document 3: M.H. Levitt, P.K. Madhu, C.E. Hughes, Journal of Magnetic Resonance, vol. 155, pp. 300-306 (2002).

## SUMMARY OF THE INVENTION

[Approach Using Differences in RF Magnetic Field Strength]

The above-described DEPTH sequence operates quite well. However, the greatest problem is that a large number of phase cycling steps are required. In principle, as many as 64 phase cycling steps are needed. The number of phase cycling steps can be reduced to 16, at best. Therefore, in the case of a highly sensitive sample that does not need a large number of signal accumulations, at least 64 (or 16) accumulations are needed. That is, an excessive number of accumulations are necessary to complete the phase cycling process. This presents the problem that the measurement time is prolonged unnecessarily.

This problem is often encountered in $^{19}$F NMR measurements. Furthermore, if the signal from the sample is quite weak and signal accumulations are necessary, the number of accumulations can be set only in increments of 64 or 16. This allows less latitude in setting the number of accumulations.

The present invention is based on the above-described approach using differences in RF magnetic field strength. It is desirable to provide a technique which alleviates the problem that less latitude is given in setting the number of accumulations and which achieves background suppression with fewer phase cycling steps.

The present invention provides a method of NMR measurement, the method being adapted to reduce a background-derived signal emanating from the material of an NMR probe. This method starts with applying an RF pulse sequence consisting of a 90° pulse and subsequent one or more 180° pulses to a sample to induce an NMR signal and detecting the NMR signal. The application is repeated while varying the RF phase of each pulse in accordance with a phase cycling scheme to induce NMR signals, and the NMR signals are detected. The detected NMR signals are accumulated. The phase cycling scheme is a cogwheel phase-cycling scheme.

The present invention also provides a method of NMR measurement for reducing background-derived signals emanating from an NMR probe. This method starts with applying an RF pulse sequence consisting of a 90° pulse and subsequent one or more 180° pulses to a sample to induce an NMR signal and detecting the NMR signal. The application is repeated while varying the RF phase of each pulse in accordance with a phase cycling scheme. The detected NMR signals are accumulated. In the phase cycling scheme, the RF phase of the 90° pulse is varied in N increments of $2\pi m \nu_0/N$ (m = 0, 1, ..., N - 1) whenever N measurements are made. The RF phase of the 180° pulse or pulses ($180_1$, $180_2$, ..., $180_i$) following the 90° pulse is set equal to $2\pi m \nu_i/N$ (i = 1, 2, ...) whenever a measurement is made. N is the total number of required phase cycling steps. $\nu_0$ is a coefficient about the 90° pulse. $\nu_i$ is a coefficient about the 180° pulse or pulses ($180_i$).

In one feature of this method, optimum values of the N and $\nu_i$ are previously selected based on a simulation.

In one feature of these methods of NMR measurement, the 90° pulse is a single pulse or a pulse sequence producing transverse magnetization from nuclear magnetization functionally equivalently to a 90° pulse.

The method of NMR measurement of the present invention is adapted to reduce background-derived signals emanating from the material of an NMR probe. The method starts with applying an RF pulse sequence consisting of a 90° pulse and one or more following 180° pulses to a sample to induce an NMR signal and detecting the NMR signal. The application is repeated while varying the RF phase of each pulse in accordance with a phase cycling scheme to induce NMR signals, and the NMR signals are detected. The detected NMR signals are accumulated. Since the phase cycling scheme is a cogwheel phase-cycling scheme, it is possible to alleviate the problem that less latitude is allowed in setting the number of accumulations while based on an approach using differences in RF magnetic field strength. Background suppression can be achieved with less phase cycling steps.

This invention also provides apparatus, such as an NMR spectrometer, arranged to put into effect the described method steps.

## BRIEF DESCRIPTION OF THE DRAWINGS

FIG. 1 is a diagram illustrating a conventional approach taken while taking notice of NMR probe materials.

FIG. 2 is a diagram illustrating another conventional approach using differences in RF magnetic field strength.

FIG. 3 is a diagram illustrating a method of NMR measurement according to a first embodiment of the present invention.

FIG. 4 shows NMR background spectra acquired by a method of NMR measurement according to the invention.

FIG. 5 is a diagram illustrating a method of NMR measurement according to a second embodiment of the present invention.

## DETAILED DESCRIPTION OF THE INVENTION

The preferred embodiments of the present invention are hereinafter described with reference to the drawings.

Embodiment 1

We have discovered that the approach DEPTH taken while paying attention to differences in RF magnetic field strength B1 can be essentially attributed to coherence selection.

On the other hand, cogwheel phase cycling has been proposed as one technique for reducing the number of phase cycling steps while taking notice of coherence selection (non-patent document 3). In this cogwheel phase cycling, a pulse sequence consisting of plural pulses is divided into plural blocks. Whenever a measurement is performed, the RF phases of the blocks are simultaneously increased by their respective factors (at their respective ratios). This technique yields the same advantageous effects as the prior art phase cycling although the number of phase cycling steps is fewer.

This cogwheel phase cycling has been used, for example, in MQ-MAS (multiple-quantum magic-angle spinning) for solid-state NMR spectroscopy but has not been used for DEPTH.

In the present invention, cogwheel phase cycling is applied to DEPTH. Thus, background suppression is achieved with fewer phase cycling steps. This is described in further detail below.

The concept "coherence" is available to evaluate the effects of NMR pulses. This describes the behavior of magnetization produced by each pulse. It is known that equilibrium magnetization assumes a coherence order of 0, transverse magnetization assumes coherence orders of $\pm$ 1, and magnetization being observed assumes a coherence order of - 1. Coherence can be transferred to a different order only when a pulse is applied. Checking the coherence transfer pathways assists in deeply understanding the role of the pulses.

At equilibrium magnetization, coherence is in a state of 0. When a 90° pulse is applied, coherence is transferred to a state of + 1 or - 1 or to a mixed state thereof. Then, a 180° pulse is applied. The coherence of + 1 is transferred to - 1, and the coherence of - 1 is transferred to + 1. Finally, only the signal in the coherence of - 1 is observed.

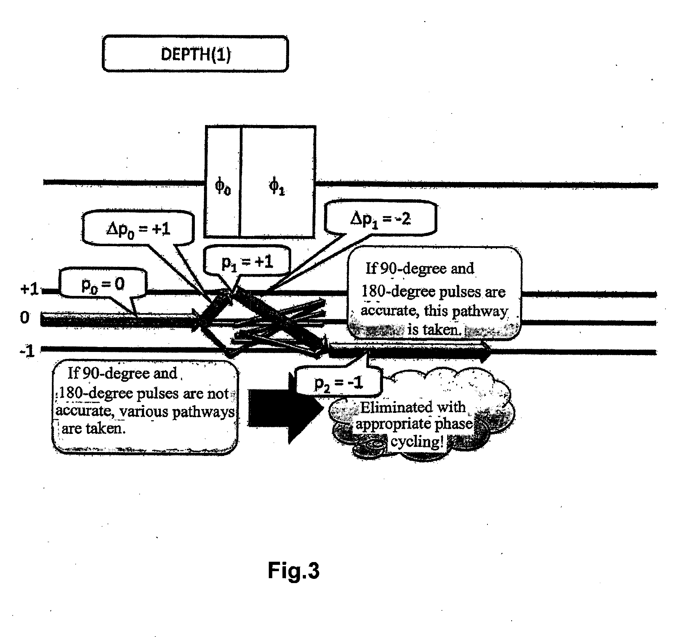

An appropriate phase is given to each pulse. When 90° and 180° pulses are perfect, DEPTH1 follows only a coherence transfer pathway of 0 → + 1 → - 1 as indicated by the thick arrow in FIG. 3. However, when the 90° pulse deviates from 90 degrees or when the 180° pulse deviates from 180 degrees, DEPTH1 takes various other coherence transfer pathways indicated by the thin arrows, as well as the above-described pathway. As there are more pulse deviations, more different pathways are taken.

The substance of the probe material which provides the background signal feels weaker RF magnetic field strength than the sample. If the pulse width is so adjusted that a 90° pulse and a 180° pulse appear at the sample position, RF pulses having values greatly different from the 90° and 180° pulses at the material position are obtained. That is, there are quite many signals taking other pathways as described in connection with FIG. 3.

Signals of magnetizations taking other pathways can be removed from signals of magnetizations taking the normal pathway by observing and summing up signals while appropriately varying the phases of 90° and 180° pulses. That is, signals taking other pathways can be suppressed by subjecting only the normal pathway to coherence selection. Consequently, the background signal can be suppressed while observing the signal from the sample.

[Interpretation from Coherence Selection of Conventional Phase Cycling]

Coherence selection is achieved by performing plural measurements while varying the pulse phases and summing up the resulting signals. This approach is known as phase cycling. The phases of pulses applied in turn are indicated by $\phi_i$ (i = 0, 1, 2, ...). Coherence between the (i - 1)th pulse and the ith pulse is defined to have an order of $p_i$, it being noted that $p_0$ = 0. The difference between coherences transferred by their respective pulses is given by $\Delta p_i = p_{i+1} - p_i$. The phase of a signal to be observed is given by the following relational formula, and is set to the phase $\phi_{rec}$ of a reference signal for an NMR phase detection circuit. Signals are summed up while varying the phases of the pulses. Thus, coherence selection is achieved.

$$\phi_{rec} = -\sum_i \Delta p_i \, \phi_i \qquad (1)$$

A method of varying the phases of the pulses is given by

$$\phi_i^{(k)} = k \, \frac{2\pi}{N_i} \qquad (2)$$

where $\phi_i^{(k)}$ is a value that $\phi_i$ should assume at the kth phase cycling step of $\phi_i$. k is varied from 0 to $N_i$ - 1. $N_i$ indicates the number of pathways from which one pathway is selected. That is, $N_i$ phase cycling steps are required for each pulse. Consequently, the number of phase cycling steps required in total is given by

$$N = \prod_i N_i \qquad (3)$$

With respect to DEPTH1, it is now assumed that a 90° pulse, a 180° pulse, and an observed signal have phases of $\phi_0$, $\phi_1$, and $\phi_{rec}$, respectively. $\Delta p_0$ going through a normal coherence transfer pathway is a transfer of coherence from 0 order to + 1 order. Thus, we have $\Delta p_0$= + 1. Since $\Delta p_1$ is a transfer from + 1 order to - 1 order, we have $\Delta p_2$ = - 2. One is selected from three pathways. Therefore, $N_0 = N_1 = 3$. In consequence, $\phi_0$ needs $N_0$ phase cycling steps. For each $\phi_0$, phase cycling of $\phi_1$ needs to be done $N_1$ times. That is, the number of phase cycling steps required in total is $N_0 \times$

$N_1$ = 9 at minimum. In order to obtain a spectrum in which the background is suppressed, 9 experiments need to be carried out with different phases. Generally, $N_i$ that is a multiple of 4 is preferred and, therefore, $N_0 = N_1 = 4$ is used often. In this case, the number of phase cycling steps required in total is 16.

In the case of DEPTH2, $(\Delta p_0, \Delta p_1, \Delta p_2)$ = (- 1, + 2, - 2), $(N_0, N_1, N_2)$ = (3, 3, 3). The number of phase cycling steps required is 27 at minimum. Generally, a multiple of 4 is used, in which case 64 phase cycling steps are required.

Generally, in the case of DEPTHn, $3^n$ phase cycling steps are required at minimum. It can be seen that where n is large, a very large number of phase cycling steps are necessary.

In the DEPTH2 that has been already reported and is widely used, 64 phase cycling steps is used employing a multiple of 4. It is reported that the number of phase cycling steps can be empirically reduced down to 16 (non-patent document 1).

[Cogwheel Phase Cycling]

As noted above, when many pulses are applied, the number of phase cycling steps required increases exponentially. In this case, a very large number of measurements are needed, and an exorbitantly long measurement time is taken. As a general theory that solves this problem, cogwheel phase cycling that is an efficient phase cycling method has been proposed (non-patent document 3).

Unlike the above-described approach in which the phases of pulses are varied independently, this approach is **characterized in that** a pulse sequence consisting of plural pulses is divided into plural blocks and that the RF phases of the blocks are increased simultaneously by their respective factors (ratios) whenever a measurement is performed. As a result, an efficient phase cycling process is achieved.

Phase cycling in a cogwheel phase cycling process is given by

$$\phi_i^{(m)} = \frac{2\pi v_i}{N} m \qquad (4)$$

where N is the total number of phase cycling steps required, $\phi_i^{(m)}$ is a phase that the phase $\phi_i$ of the ith block should assume at the mth phase cycling step (where m = 0, 1, ... , N - 1). $v_i$ is known as a winding number and is a coefficient (integer) indicating a magnification determined about the ith block. A winding number difference is defined as follows.

$$\Delta v_i = v_{i+1} - v_i \qquad (5)$$

At this time, N and the winding number $v_i$ are appropriately set. With respect to the order $p_i^{trial}$ of a coherence that can be assumed between the (i - 1)th block and the ith block, the following equation is evaluated.

$$\sum_i \Delta v_i \Delta p_{i+1}^{trial} = \sum_i \Delta v_i \Delta p_{i+1} + N \times \text{integer} \qquad (6)$$

If $\Delta v_i$ and N exist at which this equation does not hold for every possible coherence pathway where $\Delta p_{i+1}^{trial} \neq \Delta p_{i+1}$, then it is possible to perform efficient phase cycling using their values. $v_0$ (the winding number of the initial block) can assume any arbitrary value. Assuming that this winding number is equal to 0, for example, every $v_i$ can be determined from $\Delta v_i$ of Eq. (5). The phases of the pulses can be determined from $v_i$ and N using Eq. (4). At this time, the phase of the observed signal can be determined from Eq. (1).

Since the publication of the approach, it has been shown that the approach can be applied to MQMAS (Multiple-Quantum Magic-Angle Spinning), TOSS (TOtal Sideband Suppression), and PASS (Phase-Adjusted Spinning Sidebands) measurements. It has been demonstrated that efficient coherence selection is achieved with a quite small number of phase cycling steps N.

When a desired winding number is searched for, it is necessary to make an exhaustive search. Computer programs such as CCCP++ are offered for this purpose. It is possible to find the solution using such a program. It is known that N needed when cogwheel phase cycling is used is far smaller than the number (given by Eq. (3)) of phase cycling steps required heretofore.

For example, in the case of TOSS, 81 phase cycling steps have been required in the past. It has been shown that the number can be reduced down to 9 by the use of cogwheel phase cycling. Furthermore, cogwheel phase cycling provides higher efficiency with increasing the number of pulses compared with the conventional phase cycling method.

[Application of Cogwheel Phase Cycling to DEPTH]

In the DEPTH sequence relying on the conventional method, phase selection is done based on the conventional phase cycling process in which the phases of pulses are varied independently, thus suppressing the background signal. Therefore, in the DEPTH1, at least 9 phase cycling steps are required. In the DEPTH2, at least 27 phase cycling steps are required. In the DEPTHn, at least $3^n$ phase cycling steps are required. In this way, very large numbers of phase cycling steps are necessary.

Based on the novel concept that cogwheel phase cycling is applied to DEPTH, the present invention reduces the number of required phase cycling steps. In the case of DEPTH1, it is required to pass through a coherence pathway given by

$$(p_0, p_1, p_2) = (0, +1, -1)$$

In the prior art method, the phase cycling passing through this coherence pathway needs $3^2 = 9$ phase cycling steps. If cogwheel phase cycling is applied to DEPTH1, and if searches are made for winding numbers and phase cycling numbers N, many solutions will be obtained. N = 5 gives a solution having the least N. There are plural solutions with N = 5. As one example, a solution of $(v_0, v_1) = (0, 3)$ is obtained. At this time, phase cycling is given by

$$\left(\phi_0^{(0)}, \phi_1^{(0)}, \phi_{rec}^{(0)}\right) = 2\pi(0,0,0)$$

$$\left(\phi_0^{(1)}, \phi_1^{(1)}, \phi_{rec}^{(1)}\right) = 2\pi\left(0, \frac{3}{5}, \frac{1}{5}\right)$$

$$\left(\phi_0^{(2)}, \phi_1^{(2)}, \phi_{rec}^{(2)}\right) = 2\pi\left(0, \frac{6}{5}, \frac{2}{5}\right)$$

$$\left(\phi_0^{(3)}, \phi_1^{(3)}, \phi_{rec}^{(3)}\right) = 2\pi\left(0, \frac{9}{5}, \frac{3}{5}\right)$$

$$\left(\phi_0^{(4)}, \phi_1^{(4)}, \phi_{rec}^{(4)}\right) = 2\pi\left(0, \frac{12}{5}, \frac{4}{5}\right)$$

Only a signal passing through a coherence pathway, $((p_0, p_1, p_2) = (0, +1, -1))$, is obtained by summing up the results of these five measurements performed with this phase cycling process. Consequently, efficient background suppression is achieved.

In the conventional method, 9 phase cycling steps have been required. In the present invention, background suppression is completed by 5 phase cycling steps.

As the number of 180° pulses increases, the difference between the conventional method and the present invention becomes more conspicuous. In the case of the DEPTH2, at least 27 phase cycling steps are required in the conventional method. In accordance with the present invention, the process ends with 7 phase cycling steps because there is a solution with N = 7. A coherence pathway to be selected in DEPTH2 is $(p_0, p_1, p_2, p_3) = (0, -1, +1, -1)$. One cogwheel phase cycling solution satisfying this requirement is given by

$$\left(\phi_0^{(0)}, \phi_1^{(0)}, \phi_2^{(0)}, \phi_{rec}^{(0)}\right) = 2\pi(0,0,0,0)$$

$$\left(\phi_0^{(1)}, \phi_1^{(1)}, \phi_2^{(1)}, \phi_{rec}^{(1)}\right) = 2\pi\left(\frac{5}{7},0,\frac{5}{7},\frac{1}{7}\right)$$

$$\left(\phi_0^{(2)}, \phi_1^{(2)}, \phi_2^{(2)}, \phi_{rec}^{(2)}\right) = 2\pi\left(\frac{10}{7},0,\frac{10}{7},\frac{2}{7}\right)$$

$$\left(\phi_0^{(3)}, \phi_1^{(3)}, \phi_2^{(3)}, \phi_{rec}^{(3)}\right) = 2\pi\left(\frac{15}{7},0,\frac{15}{7},\frac{3}{7}\right)$$

$$\left(\phi_0^{(4)}, \phi_1^{(4)}, \phi_2^{(4)}, \phi_{rec}^{(4)}\right) = 2\pi\left(\frac{20}{7},0,\frac{20}{7},\frac{4}{7}\right)$$

$$\left(\phi_0^{(5)}, \phi_1^{(5)}, \phi_2^{(5)}, \phi_{rec}^{(5)}\right) = 2\pi\left(\frac{25}{7},0,\frac{25}{7},\frac{5}{7}\right)$$

$$\left(\phi_0^{(6)}, \phi_1^{(6)}, \phi_2^{(6)}, \phi_{rec}^{(6)}\right) = 2\pi\left(\frac{30}{7},0,\frac{30}{7},\frac{6}{7}\right)$$

Seven measurements are performed using this phase cycling scheme. The results are summed up, thus completing a coherence pathway selection of $(p_0, p_1, p_2, p_3) = (0, -1, +1, -1)$. A great reduction in the number of phase cycling steps compared with the conventional method, i.e., from 27 to 7, can be accomplished.

In the case of DEPTH3 consisting of three 180° pulses, 81 phase cycling steps have been necessary in the conventional method. On the other hand, where a cogwheel phase cycling scheme is used, a solution with N = 9 is obtained as follows as a solution having a minimum N.

$$\left(\phi_0^{(0)}, \phi_1^{(0)}, \phi_2^{(0)}, \phi_3^{(0)}, \phi_{rec}^{(0)}\right) = 2\pi(0,0,0,0,0)$$

$$\left(\phi_0{}^{(1)}, \phi_1{}^{(1)}, \phi_2{}^{(1)}, \phi_3{}^{(1)}, \phi_{rec}{}^{(1)}\right) = 2\pi\left(0, \frac{7}{9}, 0, \frac{7}{9}, \frac{1}{9}\right)$$

$$\left(\phi_0{}^{(2)}, \phi_1{}^{(2)}, \phi_2{}^{(2)}, \phi_3{}^{(2)}, \phi_{rec}{}^{(2)}\right) = 2\pi\left(0, \frac{14}{9}, 0, \frac{14}{9}, \frac{2}{9}\right)$$

$$\left(\phi_0{}^{(3)}, \phi_1{}^{(3)}, \phi_2{}^{(3)}, \phi_3{}^{(3)}, \phi_{rec}{}^{(3)}\right) = 2\pi\left(0, \frac{21}{9}, 0, \frac{21}{9}, \frac{3}{9}\right)$$

$$\left(\phi_0{}^{(4)}, \phi_1{}^{(4)}, \phi_2{}^{(4)}, \phi_3{}^{(4)}, \phi_{rec}{}^{(4)}\right) = 2\pi\left(0, \frac{28}{9}, 0, \frac{28}{9}, \frac{4}{9}\right)$$

$$\left(\phi_0{}^{(5)}, \phi_1{}^{(5)}, \phi_2{}^{(5)}, \phi_3{}^{(5)}, \phi_{rec}{}^{(5)}\right) = 2\pi\left(0, \frac{35}{9}, 0, \frac{35}{9}, \frac{5}{9}\right)$$

$$\left(\phi_0{}^{(6)}, \phi_1{}^{(6)}, \phi_2{}^{(6)}, \phi_3{}^{(6)}, \phi_{rec}{}^{(6)}\right) = 2\pi\left(0, \frac{42}{9}, 0, \frac{42}{9}, \frac{6}{9}\right)$$

$$\left(\phi_0{}^{(7)}, \phi_1{}^{(7)}, \phi_2{}^{(7)}, \phi_3{}^{(7)}, \phi_{rec}{}^{(7)}\right) = 2\pi\left(0, \frac{49}{9}, 0, \frac{49}{9}, \frac{7}{9}\right)$$

$$\left(\phi_0{}^{(8)}, \phi_1{}^{(8)}, \phi_2{}^{(8)}, \phi_3{}^{(8)}, \phi_{rec}{}^{(8)}\right) = 2\pi\left(0, \frac{56}{9}, 0, \frac{56}{9}, \frac{8}{9}\right)$$

In the conventional method, 81 phase cycling steps have been required in this way. The present invention makes it possible to reduce the number of phase cycling steps down to only 9.

In DEPTH4 consisting of four 180° pulses, when the conventional method is used, 273 phase cycling steps have been required. The present invention makes it possible to reduce the number of phase cycling steps down to 11, because there is a solution with N = 11 as follows.

$$\left(\phi_0{}^{(0)},\phi_1{}^{(0)},\phi_2{}^{(0)},\phi_3{}^{(0)},\phi_4{}^{(0)},\phi_{rec}{}^{(0)}\right)=2\pi\left(0,0,0,0,0,0\right)$$

$$\left(\phi_0{}^{(1)},\phi_1{}^{(1)},\phi_2{}^{(1)},\phi_3{}^{(1)},\phi_4{}^{(1)},\phi_{rec}{}^{(1)}\right)=2\pi\left(\frac{9}{11},0,\frac{9}{11},0,\frac{9}{11},\frac{1}{11}\right)$$

$$\left(\phi_0{}^{(2)},\phi_1{}^{(2)},\phi_2{}^{(2)},\phi_3{}^{(2)},\phi_4{}^{(2)},\phi_{rec}{}^{(2)}\right)=2\pi\left(\frac{18}{11},0,\frac{18}{11},0,\frac{18}{11},\frac{2}{11}\right)$$

$$\left(\phi_0{}^{(3)},\phi_1{}^{(3)},\phi_2{}^{(3)},\phi_3{}^{(3)},\phi_4{}^{(3)},\phi_{rec}{}^{(3)}\right)=2\pi\left(\frac{27}{11},0,\frac{27}{11},0,\frac{27}{11},\frac{3}{11}\right)$$

$$\left(\phi_0{}^{(4)},\phi_1{}^{(4)},\phi_2{}^{(4)},\phi_3{}^{(4)},\phi_4{}^{(4)},\phi_{rec}{}^{(4)}\right)=2\pi\left(\frac{36}{11},0,\frac{36}{11},0,\frac{36}{11},\frac{4}{11}\right)$$

$$\left(\phi_0{}^{(5)},\phi_1{}^{(5)},\phi_2{}^{(5)},\phi_3{}^{(5)},\phi_4{}^{(5)},\phi_{rec}{}^{(5)}\right)=2\pi\left(\frac{45}{11},0,\frac{45}{11},0,\frac{45}{11},\frac{5}{11}\right)$$

$$\left(\phi_0{}^{(6)},\phi_1{}^{(6)},\phi_2{}^{(6)},\phi_3{}^{(6)},\phi_4{}^{(6)},\phi_{rec}{}^{(6)}\right)=2\pi\left(\frac{54}{11},0,\frac{54}{11},0,\frac{54}{11},\frac{6}{11}\right)$$

$$\left(\phi_0{}^{(7)},\phi_1{}^{(7)},\phi_2{}^{(7)},\phi_3{}^{(7)},\phi_4{}^{(7)},\phi_{rec}{}^{(7)}\right)=2\pi\left(\frac{63}{11},0,\frac{63}{11},0,\frac{63}{11},\frac{7}{11}\right)$$

$$\left(\phi_0{}^{(8)},\phi_1{}^{(8)},\phi_2{}^{(8)},\phi_3{}^{(8)},\phi_4{}^{(8)},\phi_{rec}{}^{(8)}\right)=2\pi\left(\frac{72}{11},0,\frac{72}{11},0,\frac{72}{11},\frac{8}{11}\right)$$

Note that the above-described solutions to cogwheel phase cycling are merely exemplary and that there are plural solutions producing similar effects.

Examples of Measurement

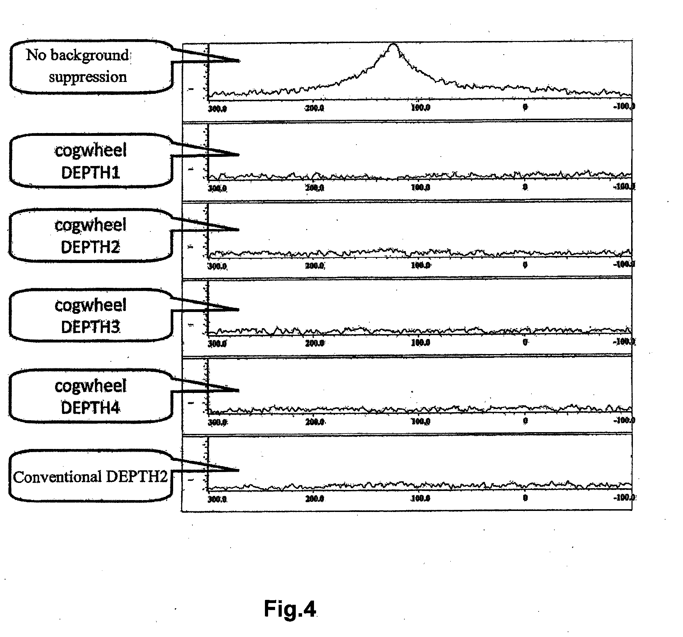

The effects of these background suppressing sequences have been confirmed by performing measurements in practice. The top of FIG. 4 is a $^{13}$C-NMR spectrum obtained by a measurement performed without background suppression. In this graph, the horizontal axis indicates the chemical shift value (in ppm) of each $^{13}$C-NMR spectrum. The vertical axis indicates the signal intensity of each $^{13}$C-NMR spectrum. A strong NMR background signal originating from $^{13}$C nuclei appears near 120 to 130 ppm.

An example in which the inventive efficient background suppression is applied to DEPTH1 is shown in the second part as viewed from above in FIG. 4. It is seen that the background signal is suppressed greatly and that the baseline is nearly flat. Similarly, the suppression works effectively in the cases of DEPTH2, DEPTH3, and DEPTH4.

Comparison of these examples of background suppression with the conventional method of DEPTH2 in terms of performance reveals that equivalent background suppression is achieved. On the other hand, the number of required phase cycling steps is much smaller than in the conventional method. In consequence, background suppression can be achieved quite efficiently.

Embodiment 2

The background signal suppression according to the present invention is achieved by applying n 180° pulses to transverse magnetization. In embodiment 1, 180° pulses are applied to transverse magnetization generated by a 90° pulse. In embodiment 2, the technique is further generalized. In embodiment 2, combinations of other pulse (e.g., a 270° pulse) or pulse sequence capable of generating transverse magnetization are set forth. If this pulse or pulse sequence is set to a single 90° pulse, then embodiment 1 is obtained.

Where n of DEPTHn is an odd number, a pulse sequence generating transverse magnetization needs a magnetization of + 1. Where n is an even number, a pulse sequence generating transverse magnetization needs a magnetization of - 1. An example of DEPTH2 is now discussed.

A pulse sequence generating transverse magnetization creates a magnetization of - 1. First, incompleteness of this pulse sequence is neglected. That is, it is assumed that immediately after this pulse sequence, only a magnetization having a coherence order of - 1 exists.

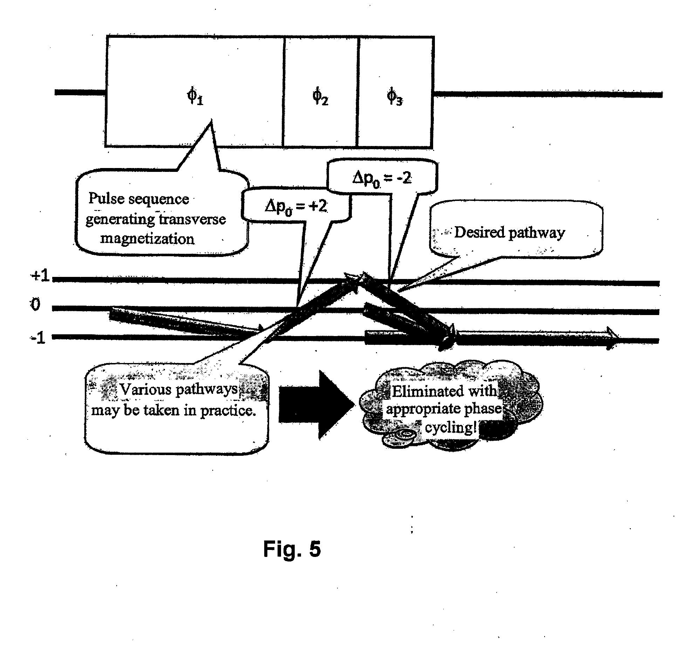

At this time, if a coherence pathway of $(p_1, p_2, p_3, p_4) = (0, - 1, + 1, - 1)$ as shown in FIG. 5 is selected, then the background signal can be suppressed.

As one example of selection of this pathway, a solution with N = 5 is given below.

$$\left(\phi_1{}^{(0)}, \phi_2{}^{(0)}, \phi_{rec}{}^{(0)}\right) = 2\pi\left(0,0,0\right)$$

$$\left(\phi_1{}^{(1)}, \phi_2{}^{(1)}, \phi_{rec}{}^{(1)}\right) = 2\pi\left(0, \frac{3}{5}, \frac{1}{5}\right)$$

$$\left(\phi_1{}^{(2)}, \phi_2{}^{(2)}, \phi_{rec}{}^{(2)}\right) = 2\pi\left(0, \frac{6}{5}, \frac{2}{5}\right)$$

$$\left(\phi_1{}^{(3)}, \phi_2{}^{(3)}, \phi_{rec}{}^{(3)}\right) = 2\pi\left(0, \frac{9}{5}, \frac{3}{5}\right)$$

$$\left(\phi_1^{(4)}, \phi_2^{(4)}, \phi_{rec}^{(4)}\right) = 2\pi\left(0, \frac{12}{5}, \frac{4}{5}\right)$$

Regarding the case of DEPTH3, an example in which N = 7 is shown below.

$$\left(\phi_1^{(0)}, \phi_2^{(0)}, \phi_3^{(0)}, \phi_{rec}^{(0)}\right) = 2\pi(0,0,0,0)$$

$$\left(\phi_1^{(1)}, \phi_2^{(1)}, \phi_3^{(1)}, \phi_{rec}^{(1)}\right) = 2\pi\left(\frac{2}{7}, 0, \frac{2}{7}, \frac{1}{7}\right)$$

$$\left(\phi_1^{(2)}, \phi_2^{(2)}, \phi_3^{(2)}, \phi_{rec}^{(2)}\right) = 2\pi\left(\frac{4}{7}, 0, \frac{4}{7}, \frac{2}{7}\right)$$

$$\left(\phi_1^{(3)}, \phi_2^{(3)}, \phi_3^{(3)}, \phi_{rec}^{(3)}\right) = 2\pi\left(\frac{6}{7}, 0, \frac{6}{7}, \frac{3}{7}\right)$$

$$\left(\phi_1^{(4)}, \phi_2^{(4)}, \phi_3^{(4)}, \phi_{rec}^{(4)}\right) = 2\pi\left(\frac{8}{7}, 0, \frac{8}{7}, \frac{4}{7}\right)$$

$$\left(\phi_1^{(5)}, \phi_2^{(5)}, \phi_3^{(5)}, \phi_{rec}^{(5)}\right) = 2\pi\left(\frac{10}{7}, 0, \frac{10}{7}, \frac{5}{7}\right)$$

$$\left(\phi_1^{(6)}, \phi_2^{(6)}, \phi_3^{(6)}, \phi_{rec}^{(6)}\right) = 2\pi\left(\frac{12}{7}, 0, \frac{12}{7}, \frac{6}{7}\right)$$

It has been assumed that magnetizations of $\pm$ 1 are created by a pulse that induces transverse magnetization. Furthermore, a phase selection employing a pulse that generates transverse magnetization can be added by subjecting $\phi_1$ to phase cycling.
The present invention can be widely applied to solid-state NMR spectroscopy and solution NMR spectroscopy.

**Claims**

1.  A method of NMR measurement for reducing a background-derived signal emanating from a material of an NMR probe used in an NMR spectrometer, said method comprising the steps of:

    applying an RF pulse sequence consisting of a 90-degree pulse and subsequent one or more 180-degree pulses to a sample to induce an NMR signal and detecting the NMR signal;
    repeating the application while varying RF phases of the pulses in accordance with a phase cycling scheme to induce NMR signals and detecting the NMR signals; and
    accumulating the detected NMR signals;
    wherein said phase cycling scheme is a cogwheel phase-cycling scheme.

2.  A method of NMR measurement for reducing a background-derived signal emanating from a material of an NMR probe used in an NMR spectrometer, said method comprising the steps of:

    applying an RF pulse sequence consisting of a 90-degree pulse and subsequent one or more 180-degree pulses to a sample to induce an NMR signal and detecting the NMR signal;
    repeating the application while varying RF phases of the pulses in accordance with a phase cycling scheme to induce NMR signals and detecting the NMR signals; and
    accumulating the detected NMR signals;
    wherein an RF phase of said 90-degree pulse is varied in N increments of $2\pi m \nu_0/N$ (where m = 0, 1, ..., N - 1) (N is the total number of required phase cycling steps; $\nu_0$ is a coefficient about the 90-degree pulse) whenever each of N measurements is performed in accordance with the phase cycling scheme; and
    wherein an RF phase of the 180-degree pulse or pulses ($180_1$, $180_2$, ..., $180_i$) following the 90-degree pulse is set equal to $2\pi m \nu_i/N$ (where i = 1, 2, ...) ($\nu_i$ is a coefficient about the 180-degree pulse ($180_i$)) whenever a measurement is performed.

3.  A method of NMR measurement as set forth in claim 2, wherein optimum values of said N and $\nu_i$ are previously selected based on a simulation.

4.  A method of NMR measurement as set forth in any one of claims 1 to 3, wherein said 90-degree pulse is a single pulse or a pulse sequence for generating transverse magnetization from nuclear magnetization functionally equivalently to a 90-degree pulse.

5.  Apparatus comprising means arranged to put into effect the steps of any of claims 1 to 4.

Any material that eliminates background signals from every nuclide does not exist!

## Fig. 1

Fig.2

Fig.3

No background suppression

cogwheel DEPTH1

cogwheel DEPTH2

cogwheel DEPTH3

cogwheel DEPTH4

Conventional DEPTH2

**Fig.4**

**Fig. 5**

Europäisches
Patentamt
European
Patent Office
Office européen
des brevets

**EUROPEAN SEARCH REPORT**

Application Number

EP 13 18 3023

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YAMINI S. AVADHUT ET AL: "Study on the Defect Structure of SnO 2 :F Nanoparticles by High-Resolution Solid-State NMR", CHEMISTRY OF MATERIALS, vol. 23, no. 6, 22 March 2011 (2011-03-22) , pages 1526-1538, XP055088488, ISSN: 0897-4756, DOI: 10.1021/cm103286t * see the sub-chapter 'Background Suppressed 1D/2D 19F NMR' on page 1526 * ----- | 1-5 | INV. G01R33/46 |
| A,D | CORY D G ET AL: "Suppression of signals from the probe in bloch decay spectra", JOURNAL OF MAGNETIC RESONANCE, ACADEMIC PRESS, LONDON, GB, vol. 80, no. 1, 15 October 1988 (1988-10-15), pages 128-132, XP023960832, ISSN: 0022-2364, DOI: 10.1016/0022-2364(88)90064-9 [retrieved on 1988-10-15] * the whole document * ----- | 1,2,4,5 | |
| A,D | LEVITT M H ET AL: "Cogwheel Phase Cycling", JOURNAL OF MAGNETIC RESONANCE, ACADEMIC PRESS, ORLANDO, FL, US, vol. 155, no. 2, 1 April 2002 (2002-04-01) , pages 300-306, XP004408001, ISSN: 1090-7807, DOI: 10.1006/JMRE.2002.2520 * the whole document * ----- | 1-5 | TECHNICAL FIELDS SEARCHED (IPC)<br><br>G01R |

-/--

The present search report has been drawn up for all claims

| Place of search | Date of completion of the search | Examiner |
|---|---|---|
| Munich | 15 November 2013 | Lersch, Wilhelm |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

....................................................................

& : member of the same patent family, corresponding
    document

EPO FORM 1503 03.82 (P04C01)

Europäisches
Patentamt
European
Patent Office
Office européen
des brevets

**EUROPEAN SEARCH REPORT**

Application Number

EP 13 18 3023

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SMITA ODEDRA ET AL: "Improved background suppression inH MAS NMR using composite pulses", JOURNAL OF MAGNETIC RESONANCE, vol. 221, 24 May 2012 (2012-05-24), pages 41-50, XP028424407, ISSN: 1090-7807, DOI: 10.1016/J.JMR.2012.05.010 [retrieved on 2012-05-24] * the whole document * | 1,2,4,5 | |
| A,D | ROBIN BENDALL M ET AL: "Depth and refocusing pulses designed for multipulse NMR with surface coils", JOURNAL OF MAGNETIC RESONANCE, ACADEMIC PRESS, LONDON, GB, vol. 53, no. 3, 1 July 1983 (1983-07-01), pages 365-385, XP023962187, ISSN: 0022-2364, DOI: 10.1016/0022-2364(83)90211-1 [retrieved on 1983-07-01] * the whole document * | 1,2,4,5 | TECHNICAL FIELDS SEARCHED (IPC) |
| A | JIAN FENG ET AL: "Suppression of probe background signals via B1 field inhomogeneity", JOURNAL OF MAGNETIC RESONANCE, vol. 209, no. 2, 3 February 2011 (2011-02-03), pages 300-305, XP028372394, ISSN: 1090-7807, DOI: 10.1016/J.JMR.2011.01.023 [retrieved on 2011-02-03] * the whole document * | 1,2,4,5 | |

The present search report has been drawn up for all claims

| Place of search | Date of completion of the search | Examiner |
|---|---|---|
| Munich | 15 November 2013 | Lersch, Wilhelm |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **D.G. CORY ; W.M. RITCHEY.** *Journal of Magnetic Resonance,* 1988, vol. 80, 128-132
- **M.R. BENDALL ; R.E. GORDON.** *Journal of Magnetic Resonance,* 1983, vol. 53, 365-385
- **M.H. LEVITT ; P.K. MADHU ; C.E. HUGHES.** *Journal of Magnetic Resonance,* 2002, vol. 155, 300-306